# FASCICULE DE BREVET EUROPEEN

(11) **EP 2 625 534 B1**
(45) Date de publication et mention de la délivrance du brevet: **11.03.2020**
(21) Numéro de dépôt: 11770411.4
(22) Date de dépôt: 07.10.2011
(51) Int. Cl.: G01R 29/08

(54) **DISPOSITIF DE TEST ELECTROMAGNETIQUE D'UN OBJET**
VORRICHTUNG ZUM ELEKTROMAGNETISCHEN TESTEN EINES OBJEKTS
DEVICE FOR THE ELECTROMAGNETIC TESTING OF AN OBJECT

(30) Priorité: 08.10.2010 FR 1058192
(43) Date de publication de la demande: 14.08.2013
(73) Titulaire: MVG Industries, 91140 Villebon-sur-Yvette (FR)
(72) Inventeur: GARREAU, Philippe, F-75011 Paris (FR); DUCHESNE, Luc, F-91470 Angervilliers (FR); LAPORTE, Raphaël, F-92270 Bois Colombes (FR); DURAND, Ludovic, F-91460 Marcoussis (FR)
(74) Mandataire: Regimbeau
(86) Numéro de dépôt international: PCT/EP2011/067590
(87) Numéro de publication internationale: WO 2012/045877

(56) Documents cités:
- EP-A1- 0 629 865
- EP-A1- 1 724 596
- WO-A1-2010/006891
- JP-A- 2006 234 602
- US-A1- 2004 075 443

## Description

L'invention concerne un dispositif de test électromagnétique d'au moins un objet, comme par exemple un objet rayonnant.

On peut citer comme exemples de tels objets sous test une ou plusieurs antennes alimentées au moyen de câbles ou bien munies directement de leurs sources ou bien de leurs récepteurs intégrés, et pouvant fonctionner en émission et/ou en réception.

On cherche par exemple à connaître la réponse de l'antenne et du récepteur intégré d'un téléphone portable à des rayonnements électromagnétiques extérieurs.

Ou encore, on cherche par exemple à connaître la réponse d'une antenne GPS avec son récepteur embarqué à des interférences électromagnétiques extérieures.

Ou encore, on cherche par exemple à mesurer le diagramme de rayonnement d'une antenne radar dans plusieurs directions de l'espace.

Ou encore, on cherche par exemple à mesurer la sensibilité d'un téléphone portable dans plusieurs directions de l'espace.

Un tel dispositif de test électromagnétique d'au moins un objet rayonnant, comportant un réseau de sondes électromagnétiques d'émission et/ou de réception de rayonnements électromagnétiques vers ou depuis l'objet sous test, le dispositif comportant en outre une structure de support du réseau de sondes et un support de l'objet sous test, est connu.

Par exemple, le document WO 2010/006891 A1 décrit un réseau de sondes électromagnétiques réparties sur une sphère, ayant comme support de l'objet sous test un mât qui s'étend depuis un dispositif de positionnement jusqu'à proximité du centre géométrique de la sphère.

Il existe également dans l'état de la technique des réseaux de sondes en arches, en anneaux ou sur un plan, comme par exemple selon le document « Spherical Near Field Facility for Characterizing Random Emissions », de Benoît Fourestié, Jean-Charles Bolomey, Thierry Sarrebourse, Zwi Altman, Joe Wiart dans IEEE Transactions on Antennas and Propagation, Vol. 53, N°8, Août 2005.

Ces dispositifs sont disposés dans une chambre anéchoïque, pour éviter les réflexions parasites des rayonnements, et faradisée pour s'affranchir des perturbations électromagnétiques extérieures.

Le document JP-A-2006 234 602 concerne un dispositif selon le préambule de la revendication 1.

L'un des inconvénients de ces dispositifs connus et disposés dans une chambre anéchoïque faradisée est la taille souvent importante des chambres qui nécessitent la construction de grands bâtiments et l'utilisation de quantités importantes d'absorbeurs électromagnétiques pour couvrir les grandes surfaces intérieures, ce qui entraine des coûts et des délais importants.

Un autre inconvénient est que l'installation de la chambre anéchoïque faradisée est souvent réalisée par une entité différente de celle qui installe le système de mesure à l'intérieur de la chambre, ce qui représente un risque supplémentaire pour les projets, tant d'un point de vue organisationnel et de planning que d'un point de vue de la responsabilité finale des performances du mesure du moyen final.

Un autre inconvénient est que la qualité des mesures électromagnétiques est directement tributaire de la capacité de la chambre anéchoïque faradisée à limiter les échos intérieurs et les perturbations extérieures nécessitant d'une part des absorbeurs électromagnétiques performant et d'autre part un blindage électromagnétique sévère, ce qui peut s'avérer d'un coût élevé.

Un autre inconvénient est que la présence d'équipements ou de pièces de support mécaniques réfléchissants ou diffractants les ondes électromagnétiques à proximité des sondes de mesure peut dégrader la qualité des mesures.

L'invention vise à obtenir un dispositif de test électromagnétique palliant les inconvénients de l'état de la technique.

A cet effet, l'invention concerne un dispositif de test électromagnétique d'au moins un objet selon la revendication 1.

Le dispositif de test suivant l'invention est à "faradisation" intégrée, ce qui signifie qu'au lieu d'avoir une chambre faradisée qui soit désolidarisée du moyen de mesure formé par les sondes, l'invention propose une chambre faradisée faisant partie intégrante du moyen de mesure, avec tous les avantages que cela comporte en termes de réduction de taille de la chambre, de réduction des travaux de génie civil nécessaires, de réduction de durée d'installation, de réduction des quantités d'absorbeurs utilisés, de réduction des coûts, de mobilité.

En effet, l'état de la technique consiste à placer le moyen de mesure, comme par exemple le réseau de sondes décrit dans le document WO 2010/006891 A1, dans une chambre faradisée et anéchoïque indépendante.

Ainsi, au lieu d'avoir une chambre anéchoïque désolidarisée du moyen de mesure, le dispositif suivant l'invention propose une chambre anéchoïque faisant partie du moyen de mesure avec des absorbeurs électromagnétiques entre les sondes et tous les avantages que cela comporte en termes de réduction de volume de la chambre, de réduction de la surface couverte par les absorbeurs, de réduction des coûts, de mobilité. Notamment, le dispositif de test suivant l'invention pourra être déménageable beaucoup plus aisément en tout lieu, y compris en dehors d'une chambre anéchoïque classique.

En outre, le dispositif suivant l'invention offre toujours le même environnement électromagnétique contrôlé à l'avance autour de l'objet sous test, ce qui garantit une qualité constante des mesures.

Dans un mode de réalisation de l'invention, la paroi conductrice est courbe. Dans un autre mode de réalisation de l'invention, la paroi conductrice peut être à facettes.

Dans un mode de réalisation de l'invention, la structure de support est de forme générale sphérique.

Dans un mode de réalisation de l'invention, la structure de support comporte au moins un montant auquel sont fixées les sondes et la au moins une paroi conductrice, des absorbeurs électromagnétiques anéchoïques étant également prévus en outre sur le côté intérieur des montants dans les intervalles entre les sondes.

Dans un mode de réalisation de l'invention, la au moins une paroi conductrice est fixée au côté extérieur du au moins un montant par l'intermédiaire d'au moins un joint radiofréquence.

Dans un mode de réalisation de l'invention, la structure (3) de support du réseau de sondes (2) comporte une première partie (3001) de support d'un premier groupe de sondes (2), fixée sur un socle inférieur (3002), et une deuxième partie (3003) de support d'un deuxième groupe de sondes (2), déplaçable sur le socle inférieur (3002) entre l'une et l'autre d'une première position fermée contre la première partie (3001) pour former la cage de Faraday, et d'une deuxième position écartée par rapport à la première partie (3001) pour ménager un espace libre (3010) de passage entre la première partie (3001) et la deuxième partie (3003).

Dans un mode de réalisation de l'invention, la deuxième partie (3003) est articulée autour d'un axe vertical (3004) sur le socle inférieur (3002) pour le déplacement en rotation autour de cet axe vertical (3004) entre l'une et l'autre de la première position et de la deuxième position.

Dans un mode de réalisation de l'invention, le dispositif comporte au moins un moteur (3019) pour déplacer la deuxième partie (3003) par rapport à la première partie (3001) entre l'une et l'autre de la première position et de la deuxième position, et apte dans la première position à maintenir la deuxième partie (3003) fermée contre la première partie (3001) pour former la cage de Faraday.

Dans un mode de réalisation de l'invention, la première partie (3001) et la deuxième partie (3003) comportent respectivement au moins un premier bord (3005) et au moins un deuxième bord (3006), qui sont tournés l'un vers l'autre dans la première position fermée, le premier bord (3005) et/ou le deuxième bord (3006) comportant au moins un joint élastique radiofréquence (3007) positionné pour être comprimé par l'autre des premier bord (3005) et/ou deuxième bord (3006) dans la première position fermée.

Dans un autre mode de réalisation de l'invention, le système de déplacement relatif situé à l'intérieur de la structure de support permet au moins un déplacement angulaire de rotation relative de la structure de support par rapport au support autour d'un axe géométrique vertical.

Dans un mode de réalisation de l'invention, le deuxième autre système de déplacement angulaire comporte une pluralité de rouleaux de soutien d'une surface extérieure courbe de la paroi de la structure de support sur le socle et au moins un moteur d'entraînement d'au moins l'un des rouleaux pour faire rouler dudit deuxième angle ladite surface extérieure courbe de la paroi de la structure de support par rapport au socle.

Dans un mode de réalisation de l'invention, le dispositif comporte en outre :
un organe de commande du déplacement angulaire de glissement du premier système de déplacement angulaire,
au moins un capteur de mesure d'un angle réel du support de l'objet sous test par rapport à la verticale,
une boucle d'asservissement du moteur d'entraînement en fonction de l'angle mesuré par le capteur, pour que l'angle mesuré par le capteur soit égal à une valeur constante correspondant à ladite position prescrite du support par rapport à la verticale.

Dans un mode de réalisation de l'invention, les sondes sont réparties de manière équiangle suivant au moins une coordonnée sphérique autour d'un même point cible des sondes. Dans un autre mode de réalisation de l'invention, les sondes sont réparties suivant des positions angulaires arbitraires à l'aide de moyens de coulissement manuels ou motorisés sur la structure de support des sondes autour d'un même point cible des sondes.

Dans un mode de réalisation de l'invention, il est prévu sur au moins une des sondes un système de réglage individuel de l'alignement mécanique de la sonde par rapport à un même point cible pour toutes les sondes, point cible où doit être centré l'objet sous test sur le support.

Dans un mode de réalisation de l'invention, le système de réglage individuel de l'alignement mécanique de la sonde est associé à au moins une caméra optique de détection positionnée au point cible pour mesurer l'alignement mécanique de la sonde.

Dans un mode de réalisation de l'invention, le système de réglage individuel de l'alignement mécanique de la sonde comporte une motorisation de ladite sonde sur la structure de support, pour déplacer la sonde par rapport à la structure de support suivant au moins un degré de liberté autre que suivant une direction de pointage de la sonde vers le point cible.

Dans un mode de réalisation de l'invention, il est prévu un module d'analyse de l'image fournie par la caméra pour détecter dans cette image la trace de ladite sonde et un module d'asservissement de la motorisation pour aligner la trace détectée de la sonde sur une trace de consigne correspondant à l'alignement de la sonde sur le point cible.

L'invention sera mieux comprise à la lecture de la description qui va suivre, donnée uniquement à titre d'exemple non limitatif en référence aux dessins annexés, sur lesquels :
- la figure 1 est une vue schématique de côté d'un mode de réalisation du dispositif de test suivant l'invention,
- la figure 2 est une vue schématique en perspective de dessus de l'intérieur du dispositif de test suivant un mode de réalisation de l'invention,
- la figure 3 est une autre vue schématique en perspective de dessus de l'intérieur du dispositif de test suivant un mode de réalisation de l'invention, montrant en plus le fond de la structure de support des sondes,
- la figure 4 est une vue schématique de face ouverte de côté du dispositif de test suivant un mode de réalisation de l'invention,
- la figure 5 est une vue schématique en coupe transversale d'une partie du dispositif suivant un mode de réalisation de l'invention,
- les figures 6 à 9 sont des vues schématiques de face ouverte de côté du dispositif de test suivant un mode de réalisation de l'invention dans différentes positions de glissement,
- la figure 10 est un schéma de principe d'un dispositif d'alignement d'une sonde suivant l'invention,
- la figure 11 est une vue schématique en perspective d'un mode de réalisation de l'invention dans une position ouverte,
- la figure 12 est une vue schématique en perspective du mode de réalisation de la figure 11 dans une position se rapprochant de la position fermée,
- la figure 13 est une vue schématique en perspective d'une partie du mode de réalisation des figures 11 et 12.

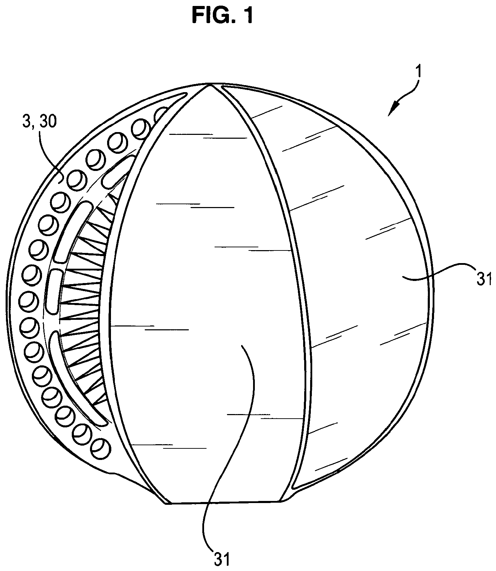

Dans le mode de réalisation représenté aux figures 1 à 9, le dispositif 1 de test électromagnétique comporte un réseau de sondes 2 électromagnétiques fixé à une structure 3 de support. La structure 3 de support comporte à cet effet des montants 30 de support des sondes 2, ces montants 30 étant par exemple en forme d'arches s'étendant verticalement et étant par exemple conducteurs.

Le dispositif 1 comporte également un support 4 d'un ou plusieurs objets sous test, ce support 4 étant par exemple formé par un mât.

La structure 3 de support comporte au moins une paroi 31 s'étendant, suivant les trois dimensions de l'espace tout autour du support 4 de l'objet sous test pour former une cage de Faraday complètement fermée autour de l'objet sous test lorsque ce dernier se trouve sur le support 4. L'objet sous test est par exemple un objet rayonnant, ainsi qu'indiqué ci-dessus. On empêche ainsi les rayonnements électromagnétiques extérieurs de pénétrer à l'intérieur de l'espace clos délimité par la structure 3 de support. On empêche également les rayonnements électromagnétiques émis par les sondes 2 et/ou les rayonnements électromagnétiques émis par l'objet sous test disposé sur le support 4 de sortir de l'espace clos délimité par la structure 3 de support. Sur les figures 1 à 4, le dispositif de test électromagnétique est représenté avec des parties de la paroi 31 de la structure de support, qui ont été enlevées, pour montrer l'intérieur de cette dernière.

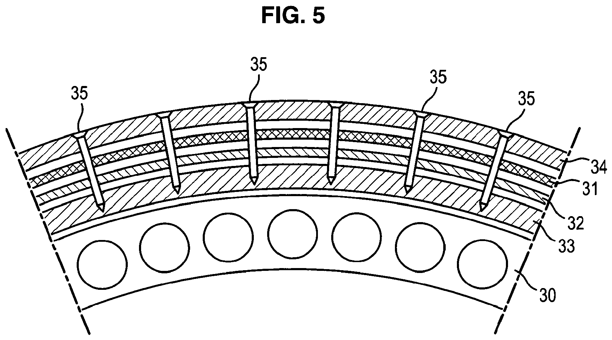

La paroi 31 ou les parois 31 est ou sont fixée(s) aux montants 30 pour empêcher toute fuite électromagnétique vers l'intérieur ou à l'extérieur, par exemple par le mode de fixation représenté à la figure 5, qui sera décrit plus en détail ci-après.

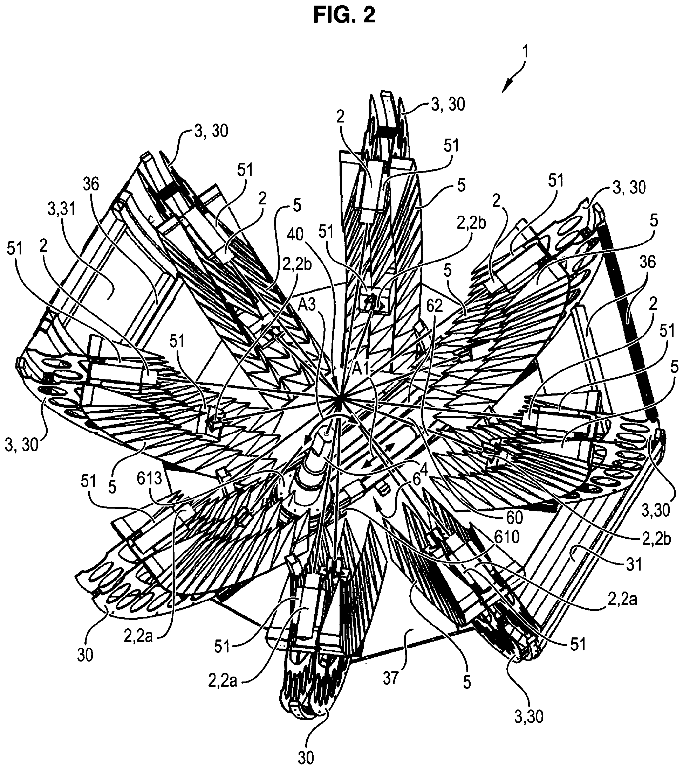

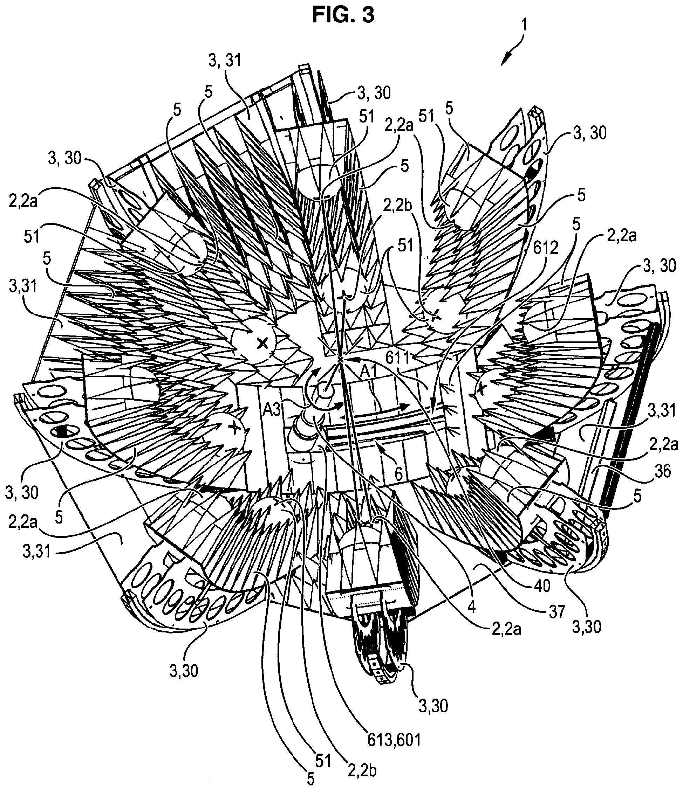

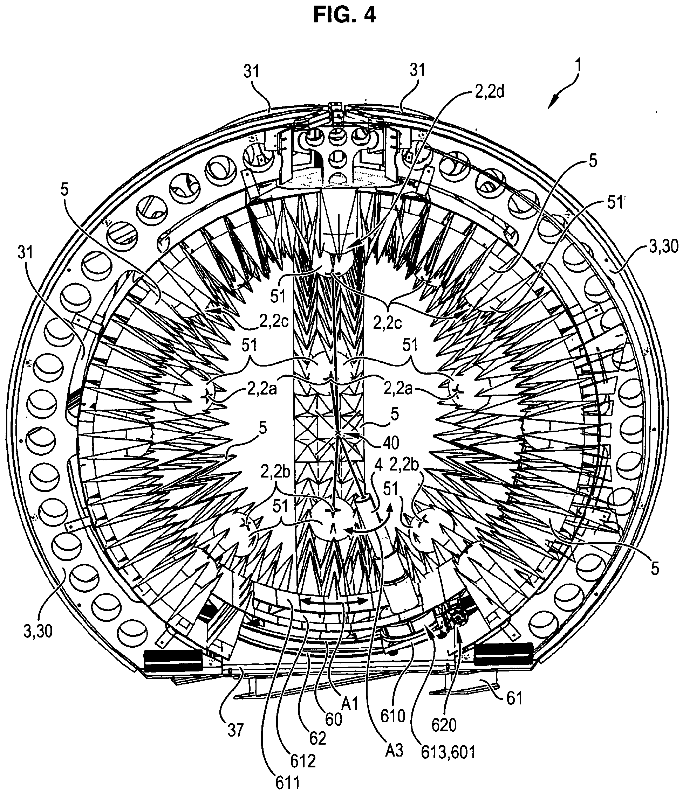

Sur son côté intérieur tourné vers l'objet sous test et le support 4, la structure 3 de support comporte des absorbeurs électromagnétiques anéchoïques 5 situés dans les intervalles entre les sondes 2. Par conséquent, les montants 30, lorsque, ainsi que représentés, ils se trouvent à l'intérieur par rapport à la paroi 31, sont recouverts d'absorbeurs électromagnétiques anéchoïques 5 tournés vers le point cible 40 des sondes 2, ce point cible 40 se trouvant en général au dessus ou à proximité du support 4 et l'objet sous test devant en général être centré en ce point test 40. La paroi 31 est recouverte, sur son côté intérieur, d'absorbeurs électromagnétiques anéchoïques 5 tournés vers le point cible 40 en lequel doit en général être centré l'objet sous test sur le support 4. Les absorbeurs électromagnétiques 5 sont par exemple pyramidaux, ainsi que représentés. Une partie d'entre eux peuvent par exemple être plats notamment pour couvrir la base 611 du système de déplacement relatif 6. Les absorbeurs 5 empêchent les rayonnements électromagnétiques émis par les sondes 2 et/ou les rayonnements électromagnétiques émis par l'objet sous test d'atteindre la ou les parois 31 et les montants 30 ou les atténuent très fortement, pour empêcher ou diminuer très fortement les réflexions pouvant être occasionnées par les montants 30 et la ou les parois 31. En effet, les montants 30 sont par exemple métalliques, notamment en acier ou aluminium. La ou les parois 31 sont conductrices et fabriquées en métal ou autre matériau conducteur pour former un mur électrique. Elles sont par exemple formées chacune d'une tôle métallique en aluminium. Les absorbeurs électromagnétiques 5 sont disposés sur toute la surface intérieure de la structure 3 à l'exception des sondes 2, lesquelles sont enrobées d'absorbeurs électromagnétiques spécifiques 51 par exemple de forme plane comme sur la figure 2 ou bien conformés comme sur les figures 3 et 4, les absorbeurs 5 se trouvant donc autour et entre les sondes 2 munies de leurs absorbeurs spécifiques 51.

Les parois 31 sont, par exemple, courbes en étant orientées vers le support 4. Il est par exemple prévu une pluralité de parois 31 avec chacune des parois 31 fixées entre deux montants 30 successifs. Les montants 30 sont, par exemple, aux figures 1 à 4, en forme d'arches semi-circulaires s'étendant le long d'un méridien d'une sphère, pour donner à la structure 3 de support une forme générale sphérique. La ou les parois 31 formant cage de Faraday peuvent n'être courbes, ainsi que représenté, que dans le sens vertical, c'est-à-dire être formées chacune d'une portion d'un cylindre ayant son axe géométrique horizontal. La ou les parois 31 formant cage de Faraday peuvent également être de forme générale sphérique. Ou encore la ou les parois 31 formant cage de Faraday peuvent également être facettées.

En outre, dans l'une des parois 31 est prévue une porte permettant à une personne de pénétrer à l'intérieur de la structure 3 pour y introduire et/ou enlever l'objet sous test sur le support 4. Une porte de type « avion » qui s'ouvre soit en une seule partie vers le haut (type coffre de voiture) ou vers le bas (type haillon de camion), soit en 2 parties (une vers le haut et l'autre vers le bas) peut par exemple être prévue. Cette porte est conformée pour suivre les courbures de la structure 3 de façon à venir presser des joints électromagnétiques sur tout le pourtour de la porte. Ces joints électromagnétiques sont par exemple des joints de type couteaux utilisés pour la faradisation des portes des chambres de mesure d'antennes.

Dans le mode de réalisation de la figure 5, une paroi 31 est fixée sur le côté extérieur d'un montant 30. Un joint radiofréquence 32 (aussi appelé joint RF) est prévu entre le montant 30 et la paroi 31 pour assurer une étanchéité vis-à-vis des rayonnements électromagnétiques entre l'intérieur et l'extérieur. De tels joints RF 32 sont, par exemple, formés d'un ruban métallique, constitué par exemple de fils métalliques tricotés. Un tel joint 32 permet de s'adapter aux formes courbes ou facettées.

En outre, un premier arceau métallique conducteur 33 est fixé au côté extérieur du montant 30, le joint RF 32 se trouvant entre le premier arceau 33 et la paroi 31. Un deuxième arceau métallique conducteur 34 est prévu sur le côté extérieur de la paroi 31 en face du joint RF 32, la paroi 31 se trouvant donc entre le deuxième arceau 34 et le joint RF 32. Le premier arceau 33, le joint RF 32, la paroi 31 et le deuxième arceau 34 sont fixés les uns aux autres par des vis 35 les traversant depuis l'extérieur. Bien entendu, tout autre moyen 35 de fixation pourrait être prévu. Ces moyens 35 de fixation permettent, en rapprochant le deuxième arceau 34 du premier arceau 33, de comprimer le joint RF 32 pour assurer la continuité du blindage électromagnétique, ainsi que de fixer la paroi 31 au montant 30.

Comme montré sur les figures 2 et 3, des traverses 36 peuvent également être prévues entre les montants 30 et derrière les absorbeurs 5 entre ceux-ci et la paroi 31, pour rigidifier la structure de support. De plus, à l'aide de ces traverses 36, le principe d'étanchéité électromagnétique décrit dans l'exemple de la figure 5 peut être réemployé pour raccorder les parois 31 d'un point de vue blindage électromagnétique dans le cas où les parois 31 sont composées de plusieurs morceaux dans le sens du méridien.

La géométrie circulaire des montants 30 dans le mode de réalisation représenté aux figures 1 à 5 permet de disposer de manière régulière les sondes 2 autour du support 4 et autour de son point cible 40 en géométrie sphérique. Par exemple, l'écartement angulaire azimutal entre les montants 30 en forme d'arches circulaires est le même pour tous les montants 30. De même l'écartement angulaire entre les sondes 2, situées sur un même montant 30, par rapport à l'axe horizontal passant par le point cible 40 et perpendiculaire au plan du montant 30 est par exemple le même pour toutes les sondes 2. Ainsi, si l'on considère que les montants 30 représentent les méridiens d'une sphère, il est par exemple prévu un premier jeu de n sondes 2, appelées 2a, situées sur un même plan équatorial passant par le point cible 40, un deuxième jeu de n sondes 2, référencées 2b, situé dans un deuxième plan parallèle au premier plan équatorial et disposé à un deuxième angle de latitude négatif par rapport au premier jeu de sondes 2a, un troisième jeu de n sondes 2, appelées 2c, situé sur un troisième plan parallèle au premier plan équatorial et écarté d'un troisième angle de latitude par rapport à ce plan équatorial, ce troisième angle ayant la même valeur absolue que le deuxième angle mais étant en sens opposé, ainsi qu'une autre sonde 2, 2d, située au sommet de la sphère, c'est-à-dire au point d'intersection supérieur des montants 30, formant le pôle nord de la sphère. Les sondes 2 sont écartées de manière équiangle dans chacun des premiers, deuxièmes et troisièmes plans indiqués ci-dessus. Le deuxième angle et le troisième angle sont par exemple égaux à 45° en valeur absolue, de même que les angles de longitude entre les méridiens formés par les montants 30. Dans le mode de réalisation représenté à la figure 2, cet angle d'écartement est par exemple identique en longitude et en latitude, en étant par exemple égal à 45°. Dans ce cas particulier de mode de réalisation, les sondes sont réparties sur m méridiens et p = m/2 - 1 plans de latitude, avec une sonde éventuellement présente au sommet de la structure 3.

Dans le mode de réalisation représenté aux figures 2 à 4, le support 4 se trouve à l'intérieur du volume clos défini par la structure 3 de support.

Un système 6 de déplacement relatif de la structure 3 de support et du support 4 de l'objet sous test l'un par rapport à l'autre est prévu à l'intérieur du volume clos défini par cette structure 3 de support et les parois 31.

Ce système 6 de déplacement permet de déplacer la structure 3 de support et le support 4 relativement l'un par rapport à l'autre suivant au moins un degré de liberté, et par exemple selon au moins deux degrés de liberté, comme par exemple suivant au moins un déplacement angulaire autour d'un axe géométrique passant par le point cible 40, pouvant comprendre par exemple un déplacement angulaire A1 dans un premier plan non horizontal et par exemple vertical, passant par le point cible 40 et/ou un autre déplacement angulaire dans un autre plan non horizontal et par exemple vertical, passant par le point cible 40 et sécant du premier plan et/ou un autre déplacement angulaire autour de l'axe géométrique vertical passant par le point cible 40. Dans le mode de réalisation représenté aux figures 2 à 4, le système 6 comporte des moyens pour effectuer un premier déplacement angulaire relatif de la structure 3 de support par rapport au support 4 suivant un premier angle A1 de glissement dans un plan non horizontal et par exemple vertical (déplacement de glissement) et effectuer l'autre déplacement angulaire relatif de rotation suivant un autre angle A3 de rotation autour de l'axe géométrique vertical passant par le point cible 40, ce qui permet d'avoir toutes les dispositions relatives possibles des sondes 2 par rapport au support 4 et au point cible 40, et permet ainsi de réaliser un suréchantillonnage spatial au moyen du réseau de sondes 2 lors d'une mesure du champ électromagnétique. Ce système 6 de déplacement relatif est, par exemple, selon le document WO 2010/006891 A1.

Le système 6 de déplacement relatif situé à l'intérieur de la structure 3 de support est composé d'au moins un premier système 60 de déplacement angulaire relatif permettant au moins un déplacement angulaire A1 déterminé de glissement de la structure 3 de support et du support 4 l'un par rapport à l'autre autour d'un axe géométrique non vertical. Ce système 6 comporte le premier système 60 de déplacement angulaire relatif de la structure 3 de support suivant le premier angle A1 de glissement. Ce premier système 60 de déplacement angulaire comporte par exemple un rail 62 de guidage en arc de cercle fixé à une partie inférieure et intérieure de la structure 3 de support, le rail 62 et la palette 610 supportée par ce rail 62 se trouvant donc à l'intérieur du volume clos défini par la structure 3 de support, les parois 31 et la partie inférieure. La palette 610 peut être déplacée angulairement suivant le premier angle A1 de glissement sur le rail 62, des moyens 620 étant prévus pour déplacer la palette 610 sur le rail 62. Un autre système 601 de déplacement relatif du support 4 de l'objet sous test et de la structure 3 de support en rotation l'un par rapport à l'autre autour d'un axe vertical est prévu, par exemple par le fait que le support 4 est monté sur la palette 610 par l'intermédiaire de moyens 613 de rotation qui permettent au support 4 de tourner par rapport à la palette 610 angulairement suivant l'angle A3 de rotation. Ces moyens 613 de rotation permettent ainsi à la structure 3 de tourner relativement autour du support 4. Les figures 3 et 4 montrent la plaque 611 de couverture du système 6, laquelle est également recouverte d'absorbeurs 5 et comporte un passage 612 pour le déplacement du support 4 dans celui-ci, une paroi inférieure conductrice 37 formant cage de Faraday étant prévue sous le système 6 de déplacement. Le systeme 6 de déplacement relatif de la structure 3 de support par rapport au support 4 de l'objet sous test se trouve donc totalement inclus à l'intérieur de la « Faradisation intégrée » du système de mesure, ce qui évite par exemple toute ouverture dans la paroi inférieure 37 et donc toute rupture de la Faradisation pour faire passer le support 4. Le système 6 est recouvert d'absorbeurs électromagnétiques 5, 51 au moyen de la plaque de couverture 611 et permet donc la continuité de l' « anéchoisation intégrée » du système de mesure ce qui évite par exemple toute rupture de la couverture d'absorbants et donc toute réflexion et/ou diffraction parasite.

Dans un mode de réalisation de l'invention, il est prévu, entre un socle inférieur 61 destiné à être posé sur le sol et la structure 3 de support, à l'intérieur de laquelle est fixé le premier système 6 de déplacement relatif de la structure 3 de support par rapport au support 4 de l'objet sous test, un autre deuxième système 63 de déplacement relatif de la structure 3 de support par rapport au socle 61. Ce deuxième système 63 de déplacement angulaire est analogue au premier système 60 de déplacement angulaire pour pouvoir déplacer dans le même premier plan vertical angulairement la structure 3 de support par rapport au socle 61, mais du deuxième angle A2 de glissement opposé au premier angle A1 de glissement (le deuxième angle A2 a même valeur absolue d'angle que le premier angle A1 mais est de sens opposé au premier angle A1), afin que le support 4 reste substantiellement dans une position prescrite verticale, pour compenser en temps réel le basculement du support 4 et s'affranchir des effets de la gravité sur ce support 4. Le deuxième angle A2 de glissement et le premier angle A1 de glissement sont autour du même axe X géométrique, qui est un axe passant par le point cible 40 et par exemple horizontal.

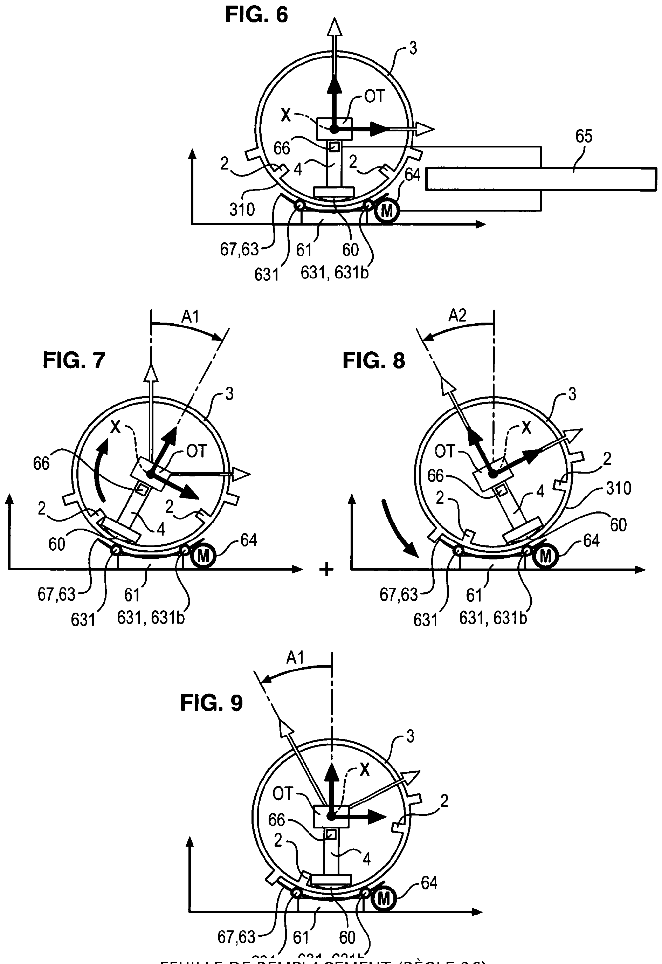

On a représenté aux figures 6 à 9 dans le premier plan vertical un exemple de réalisation du deuxième système 63 de déplacement relatif de la structure 3 de support par rapport au socle 61. Ce système 63 comporte plusieurs rouleaux 631 de soutien, de guidage et de roulement pour la surface extérieure 310 des parois 31 de la structure 3 de support, cette surface extérieure 310 étant courbe et par exemple sphérique. L'un ou plusieurs 631b des rouleaux 631 est entraîné en rotation par un moteur 64 pour faire rouler du deuxième angle A2 la surface extérieure 310 par rapport au socle 61. Les rouleaux 631 sont portés par un châssis 67 permettant le passage de la surface extérieure 310 entre les rouleaux 631, ce châssis 67 ayant par exemple une surface courbe et concave vers la surface 310, ce châssis 67 étant par exemple un berceau ou étant appelé luge de roulis et étant formé par une portion de sphère. Bien entendu, il peut être prévu plusieurs rouleaux 631 dirigés parallèlement à l'axe autour duquel se font les déplacements angulaires A1 et A2, mais également plusieurs autres rouleaux parallèles à une ou plusieurs autres directions, pour limiter la course de la surface 310 sur le châssis 67.

Un exemple de fonctionnement des systèmes 6 et 63 est décrit ci-dessous de manière décomposée et de façon fictive en référence aux figures 7 et 8, pour passer de la position de la figure 6 à la position de la figure 9.

L'utilisateur commande par un organe de commande le déplacement angulaire du premier système 60 pour déplacer la structure 3 de support des sondes 2 et le support 4 de l'objet sous test OT relativement l'un par rapport à l'autre du premier angle A1 déterminé de glissement autour du premier axe géométrique X à la figure 7. On a représenté à la figure 7 le mouvement goniométrique A1 du support 4 par rapport à la structure 3, les angles A1 et A2 étant initialement supposés nuls à la figure 6.

Sur le support 4 de l'objet sous test OT est prévu un capteur 66 de mesure de l'angle réel d'inclinaison du support 4 par rapport à la verticale. Dans la position représentée à la figure 6, ce capteur 66 mesure donc un angle réel d'inclinaison nulle par rapport à la verticale. Dans la position fictive représentée à la figure 7, ce capteur 66 mesure donc un angle réel d'inclinaison A1 par rapport à la verticale.

Le moteur 64 et le capteur 66 sont reliés à une boucle 65 d'asservissement pour commander le moteur 64 d'entraînement en fonction de l'angle réel d'inclinaison du support 4 par rapport à la verticale, mesuré de manière instantanée par le capteur 66.

La boucle 65 possède un correcteur ayant en grandeur de consigne un angle mesuré nul du capteur 66 correspondant à la position prescrite du support 4. Le correcteur agit sur la commande du moteur 64 pour corriger l'angle réel mesuré par le capteur 66 et le rendre égal à cette grandeur de consigne.

Dans la position fictive de la figure 8, cette boucle 65 d'asservissement fait tourner, par l'intermédiaire du rouleau 631b mené par le moteur 64, la surface 310 et la structure 3 de support des sondes 2 d'un angle A2 égal à l'opposé à l'angle réel A1 d'inclinaison mesuré par le capteur 66, autour de l'axe géométrique X par rapport au socle 61 fixe et au châssis 67 fixe. On a représenté à la figure 8 la rotation inverse A2 de la surface 310 de la structure 3 de support des sondes 2 par rapport au socle 61.

A la figure 9, la combinaison du mouvement goniométrique A1 de la figure 7 et de la rotation inverse A2 de la figure 8 ramène le support 4 de l'objet OT dans la position prescrite de la figure 6 par rapport à la verticale, position prescrite dite à la verticale, dans laquelle le mât 4 est considéré comme étant positionné à la verticale.

Le mouvement goniométrique A1 de la figure 7 et la rotation inverse A2 de la figure 8 sont simultanés et synchronisés par la boucle 65 d'asservissement en position. La verticalité du mât 4 est ainsi assurée en permanence. Ainsi dès que le premier système 60 veut déplacer angulairement le support 4 autour de l'axe X, la boucle 65 provoque le déplacement angulaire de la structure 3 de support des sondes 2 en sens inverse pour maintenir vertical le support 4. Les figures 7 et 8 sont fictives en ce que le mouvement goniométrique et la rotation inverse sont réalisées par petits pas successifs qui n'inclinent pas le support 4 autant qu'il est représenté. Au final, c'est à la figure 9 seulement qu'est représentée la structure 3 de support des sondes 2 qui a tourné relativement du premier angle A1 par rapport au support 4, ce dernier en restant dans la même position à la verticale pendant tout le mouvement.

En effet, le basculement du support 4 par rapport à la verticale provoquerait une flexion de celui-ci sur sa hauteur séparant le point cible 40, où doit être disposé l'objet sous test, et la structure 3 de support, ce qui fausserait le positionnement du point cible 40. En effet, une très grande précision est requise sur le positionnement du point cible 40 par rapport au point d'intersection théorique de visée des sondes 2. Le point cible 40 où est disposé l'objet sous test doit se trouver en ce point d'intersection théorique de visée des sondes 2 ou être très proche de ce point d'intersection théorique de visée des sondes 2. Par exemple, pour une fréquence de 6 GHz de fonctionnement des sondes, le point cible 40 doit se trouver dans un cube théorique de 1,5 mm de côté autour de ce point d'intersection théorique de visée des sondes 2. Pour des sondes fonctionnant à 18 GHz, le point cible 40 doit se trouver dans un cube théorique de 500 µm de côté autour de ce point d'intersection théorique de visée des sondes 2. Par conséquent, la flexion du support 4 qui est provoquée par son inclinaison par rapport à la verticale risque de faire sortir le point cible de ces tolérances de positionnement. Grâce aux deux systèmes de positionnement angulaire complémentaires mentionnés ci-dessus, à savoir le premier système 60 de positionnement angulaire du support 4 situé à l'intérieur de la structure 3 de support et le deuxième système 63 de positionnement angulaire disposé entre la structure 3 de support et le socle 61 fixe au sol, on maintient dans une position verticale prescrite le support 4 et c'est la structure 3 de support qui bouge angulairement de façon relative par rapport au socle 61 et au support 4 de l'objet sous test. Ce double système est dit antigravitationnel. Ce double système permet de disposer sur le support 4 des objets plus lourds, qui ne risquent donc pas de faire fléchir le support 4, voire d'endommager le support 4, voire de tomber du fait d'une trop forte inclinaison et ainsi de compromettre la précision des mesures, voire la faisabilité des mesures tout simplement. De plus, ce système antigravitationnel permet par exemple d'avoir des espacements angulaires entre sondes 2 plus important et donc de réduire le nombre de sondes 2 car le débattement du mouvement goniométrique du système 6 ne se trouve plus limité en amplitude par les contraintes de flexion et de torsion du support 4.

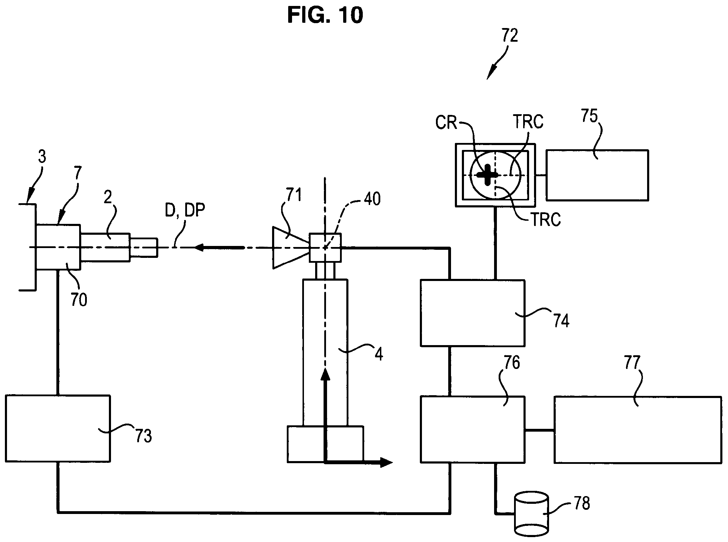

Suivant un mode de réalisation de l'invention représenté à la figure 10, il est prévu un système 7 de réglage individuel de l'alignement mécanique des sondes 2 par rapport au point cible 40. Ce système 7 de réglage d'alignement comporte, par exemple, une motorisation 70 de la sonde 2 sur sa structure 3 de support selon au moins un degré de liberté autre que suivant la direction DP de pointage de la sonde 2 vers le point cible 40 et par exemple selon au moins deux directions au niveau de chaque sonde 2, qui sont perpendiculaires ou sécantes par rapport à la direction DP de pointage de la sonde 2 vers le point cible 40. Il est prévu en outre par exemple un dispositif automatique 72 d'alignement, basé par exemple sur une caméra optique 71, par exemple du type CCD. Lors d'une phase d'installation du système de mesure ou encore d'une phase préparatoire à la mise en œuvre d'une mesure de rayonnements électromagnétiques, la caméra optique 71 est par exemple positionnée précisément au point test 40 en étant fixée sur un mât 4 de référence et est orientée successivement vers chaque sonde 2 pour contrôler par l'image prise par la caméra 71 le bon positionnement et le bon alignement de la sonde 2, la sonde 2 formant une trace identifiable CR, par exemple en forme de croix, sur l'image prise par la caméra 71. A la figure 10, le système 7 comporte un bloc 70 de motorisation de la sonde 2 sur la structure 3 de support suivant les trois dimensions de l'espace pour pouvoir déplacer la sonde 2 suivant ces trois dimensions par rapport à la structure 3, en translation et/ou en rotation. Un contrôleur multiaxe 73 permet d'actionner le bloc 70 de motorisation suivant ses degrés de liberté. La caméra 71 est reliée à un module 74 d'analyse de l'image qu'elle fournit pour détecter dans cette image la trace CR de la sonde 2, l'image de la caméra 71 pouvant être par exemple en plus affichée sur un écran 75 de contrôle. Le module 74 d'analyse d'image est relié à un module 76 de gestion, lui-même commandant le contrôleur multiaxe 73 pour asservir en positions la trace laissée par la sonde 2 dans l'image de la caméra 71 sur une trace TRC de consigne prédéterminée, correspondant au bon alignement de la direction DP de pointage sur le point test 40, cette trace TRC étant une cible logicielle. Le module 76 est donc programmé pour déplacer par l'intermédiaire du contrôleur 73 et du bloc 70 de motorisation la sonde 2 par rapport à sa structure 3 de support, pour que la trace réelle CR de la sonde coïncide avec la trace TRC de consigne. Le module 76 est relié à une interface 77 de programmation par l'utilisateur et à une mémoire 78 de sauvegarde des traces et/ou réglages effectués pour chaque sonde 2. La sonde est ensuite maintenue par le bloc 70 de motorisation dans la position d'alignement sur le point cible 40.

On garantit ainsi que chaque sonde 2 est bien alignée sur un même point cible 40 pour les mesures ultérieures pouvant être effectuées par la sonde 2.

La caméra optique peut par exemple également être couplée à une visée laser des sondes.

Les sondes 2 permettent d'envoyer ou de recevoir un rayonnement électromagnétique déterminé à l'avance vers ou depuis l'objet sous test placé au point cible 40 pour caractériser la réponse de l'objet au rayonnement électromagnétique émis. Bien entendu, il est possible d'envoyer des rayonnements électromagnétiques différents mais déterminés à l'avance suivant des lois calculées par un ordinateur pour simuler les environnements électromagnétiques en trois dimensions. Ainsi, le dispositif suivant l'invention permet de générer des scénarios électromagnétiques en trois dimensions représentant les conditions réelles du fonctionnement des appareils sous test. Ainsi, les objets pouvant être testés au point cible 40 peuvent être des objets sous tests dits « passifs » comportant une ou plusieurs antennes alimentées par des câbles ou bien être des objets sous tests dits « actifs » ou encore « sans fil » , c'est-à-dire des objet sous test ayant leur propre batterie d'alimentation ; leur propre système de réception et/ou d'émission intégré et leur propre protocole de communication.

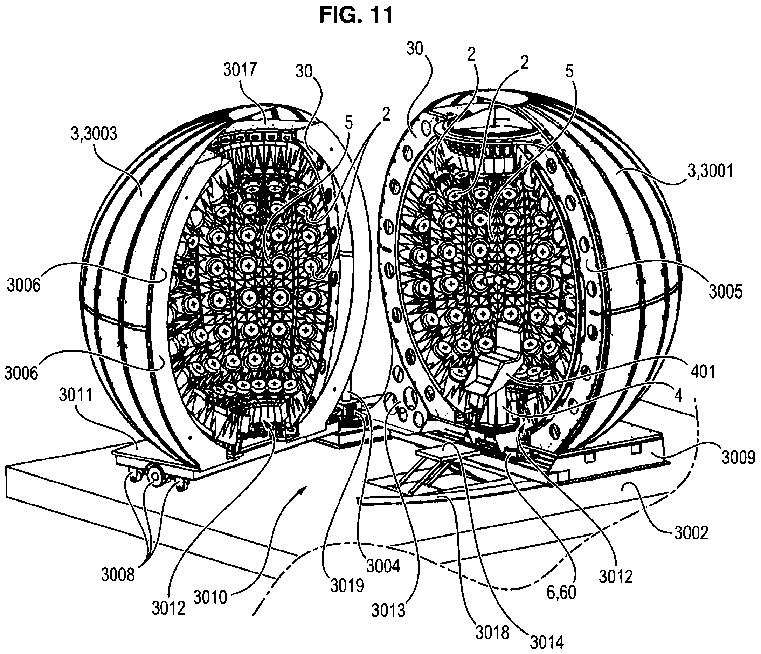

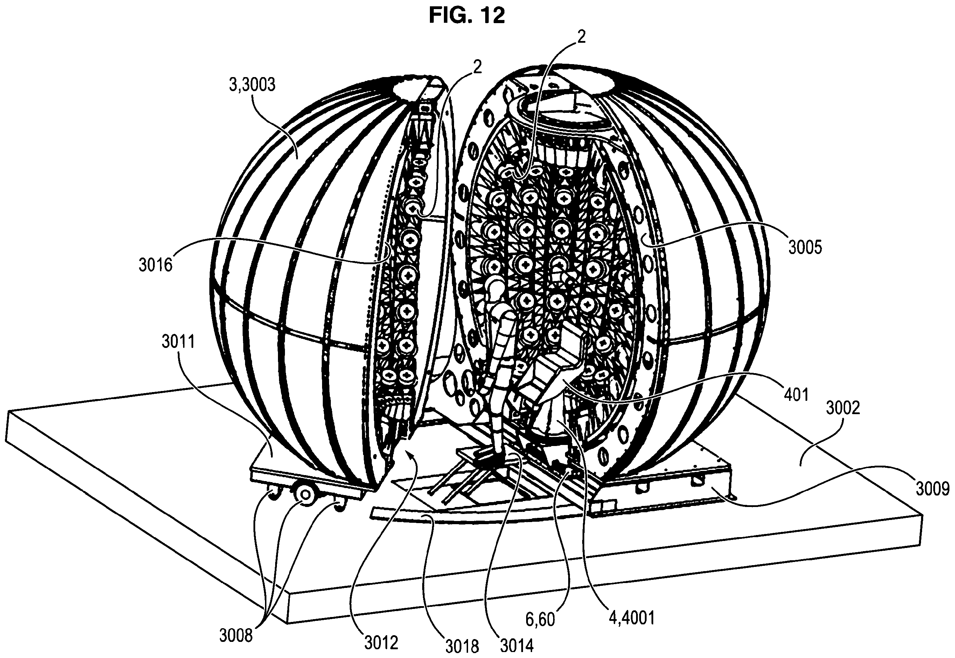

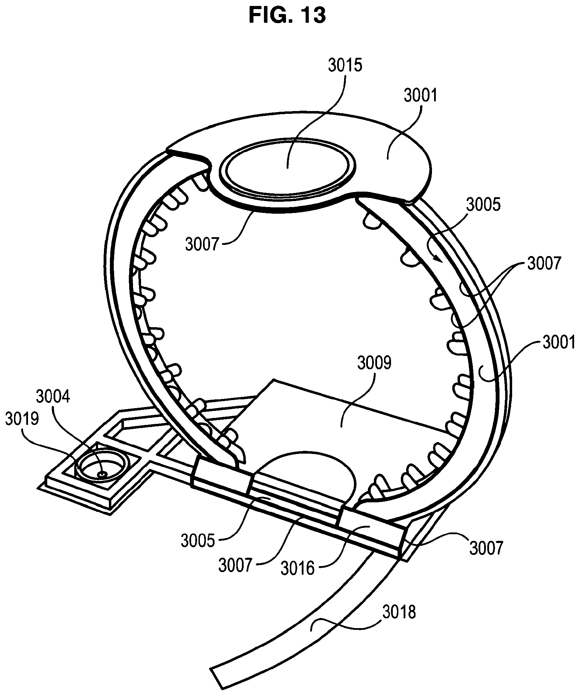

Dans le mode de réalisation représenté aux figures 11 à 13, la structure (3) de support du réseau de sondes (2) comporte une première partie (3001) de support d'un premier groupe de sondes (2), fixée sur un socle inférieur (3002), et une deuxième partie (3003) de support d'un deuxième groupe de sondes (2), déplaçable sur le socle inférieur (3002) entre l'une et l'autre d'une première position fermée contre la première partie (3001) pour former la cage de Faraday, et d'une deuxième position écartée ou ouverte par rapport à la première partie (3001) pour ménager un espace libre (3010) de passage entre la première partie (3001) et la deuxième partie (3003). Certaines des sondes 2 (premier groupe) se trouvent donc sur la première partie 3001, tandis que les autres sondes 2 se trouvent sur la deuxième partie 3003. La première partie (3001) et la deuxième partie (3003) sont par exemple formées chacune par une moitié de la structure 3 de support, en étant par exemple sensiblement hémisphériques. La séparation et l'espace libre 3010 entre les deux parties 3001 et 3003 est par exemple verticale. La première partie (3001) et la deuxième partie (3003) comportent respectivement au moins un premier bord (3005) et au moins un deuxième bord (3006), qui sont tournés l'un vers l'autre dans la première position fermée et qui sont par exemple verticaux ou perpendiculaires au socle inférieur 3002 par exemple plan.

Dans le mode de réalisation représenté aux figures 11 à 13, la deuxième partie (3003) est articulée autour d'un axe vertical (3004) sur le socle inférieur 3002 pour le déplacement en rotation autour de cet axe vertical (3004) entre l'une et l'autre de la première position et de la deuxième position.

Dans le mode de réalisation représenté aux figures 11 à 13, le dispositif comporte au moins un moteur 3019 pour déplacer la deuxième partie (3003) par rapport à la première partie (3001) entre l'une et l'autre de la première position et de la deuxième position, et apte dans la première position à maintenir la deuxième partie (3003) fermée contre la première partie (3001) pour former la cage de Faraday. Le moteur 3019 et l'axe 3004 sont situés par exemple à l'extérieur de l'espace clos, qui est délimité par les parties 3001 et 3003 dans la première position fermée. Le moteur 3019 est par exemple situé sur l'axe 3004. La première partie 3001 comporte par exemple sous les sondes 2 et sous les montants 30 une première plaque intermédiaire inférieure 3009 fixée au socle 3002. La deuxième partie 3003 comporte par exemple sous les sondes 2 et sous les montants 30 une deuxième plaque intermédiaire inférieure 3011, donc également déplaçable avec la partie 3003. Les plaques 3009 et 3011 comportent par exemple une ouverture 3012 inférieure de passage pour le support 4 de l'objet sous test. Le support 4 peut servir par exemple dans les différents modes de réalisation de l'invention à positionner une personne, par exemple en position assise sur un siège ou une chaise 401 fixé sur une partie inférieure (mât 4001) du support 4. Le système 6, 60 de déplacement relatif décrit ci-dessus peut être prévu par exemple pour déplacer le support 4 autour d'un axe non vertical par rapport à la structure 3 pour avoir un angle de glissement dans la première position fermée et fixe sur le socle 3002. Le système 601 de déplacement du support 4 pour avoir un angle de rotation sur lui-même autour d'un autre axe, décrit ci-dessus, peut également être prévu. La plaque 3011 est reliée à l'axe 3004 de rotation pour tourner autour de ce dernier. Un bras arrière inférieur 3013 est prévu entre l'axe 3004 de rotation et la partie 3001 au-dessus de la plaque 3009.

Dans le mode de réalisation représenté aux figures 11 à 13, le premier bord (3005) et/ou le deuxième bord (3006) comportent au moins un joint élastique radiofréquence (3007) positionné pour être comprimé par l'autre des premier bord (3005) et/ou deuxième bord (3006) dans la première position fermée. Ce ou ces joint(s) sont par exemple conducteur(s) de l'électricité. Par exemple, le premier bord (3005) et le deuxième bord (3006) comportent respectivement au moins un premier joint élastique radiofréquence (3007) et au moins un deuxième joint élastique radiofréquence, qui sont positionnés pour être comprimés par l'autre des premier bord (3005) et deuxième bord (3006) dans la première position fermée ou pour être comprimés l'un contre l'autre dans la première position fermée. Une continuité électrique est ainsi assurée par le ou les joints entre les bords 3005 et 3006 situés l'un en face de l'autre dans la première position fermée, pour les relier électriquement l'un à l'autre. Le ou les joints élastique(s) radiofréquence(s) sont par exemple formés par un joint réalisé en un matériau élastique, pouvant être en élastomère, par exemple du caoutchouc, des fils conducteurs de l'électricité entrelacés se trouvant dans ce matériau élastique. Ce ou ces joints sont appelés joint radiofréquence élastique métallisé. Les bords 3005 et 3006 sont par exemple plans pour exercer une pression sur l'ensemble du ou des joints dans la première position fermée. Dans la première position fermée, le moteur 3019 presse le bord 3006 contre le bord 3005 pour comprimer le ou les joints élastique(s) radiofréquence(s) et assurer la continuité électrique entre les bords 3005 et 3006. Lors du passage de la première position fermée à la deuxième position écartée, le ou les joints retrouvent leur forme initiale non comprimée. Le ou les joints élastiques radiofréquence conducteurs 3007 sont prévus sur toutes les parties en regard des parties 3001 et 3003 dans la première position fermée, à savoir sur le bord 3005 et/ou 3006, mais également sur le(s) bord(s) 3016 de la plaque 3009 et/ou 3011 (bord(s) de la plaque 3011 venant contre le bord 3016 de la plaque 3009 dans la première position fermée), et sur le bord de la couronne supérieure horizontale 3015 de la partie 3001 et/ou sur l'ouverture supérieure 3017 de la partie 3003 de forme correspondante à l'ouverture 3017 (bord(s) de la couronne supérieure horizontale 3015 venant contre le bord de l'ouverture supérieure 3017 dans la première position fermée).

Par exemple, la deuxième partie 3003 comporte en bas des roues 3008 de contact avec le socle inférieur (3002), lequel comporte par exemple une piste supérieure (3018) de roulement et de guidage pour les roues 3008 vers la partie 3001. Les roues sont par exemple montées sous la plaque 3011.

Ce mode de réalisation a l'avantage de présenter deux surfaces planes en regard l'une de l'autre au niveau de la faradisation qui est réalisée au moyen de joints élastiques métallisés fonctionnant en pression et qui retrouvent leur forme initiale lors de l'ouverture (déplacement de la première position fermée à la deuxième position écartée). La mise en œuvre de la faradisation s'en trouve largement facilitée. Un gros avantage aussi de ce mode de réalisation est le fait que la sphère est fermée avec la pression du moteur 3019. Le long des surfaces 3005 et 3006 en regard se trouvent répartis par exemple des petits ressorts d'amorçage qui se trouvent donc eux-aussi compressés dans la première position fermée. Ce qui fait que lorsqu'il y a une coupure de courant, automatiquement, le ou les moteurs 3019 relâchent la pression de fermeture et les petits ressorts amorcent l'ouverture qui se fait de façon naturelle. Cela facilite grandement toutes les procédures de sécurité en cas d'appui sur le bouton d'urgence, en cas d'incendie, en cas de coupure de courant : dans chacun des cas, on coupe le courant et la sphère s'ouvre naturellement sans action extérieure. De plus, ce type d'ouverture permet un passage aux dimensions beaucoup plus grandes et adéquat pour des actions de maintenance par exemple.

Dans la deuxième position écartée, l'espace libre (3010) de passage entre la première partie (3001) et la deuxième partie (3003) fait par exemple un angle d'ouverture compris entre 20 ° et 50°, et par exemple égal à 40°.

La taille des parties 3001 et 3003 est prévue pour pouvoir contenir une personne adulte, pour pouvoir tester un objet tenu et/ou manipulé par la personne se trouvant à l'intérieur de l'espace clos délimitée par la structure 3 dans la première position fermée. La hauteur, la largeur et la longueur des surfaces extérieures de la structure 3 de support est par exemple supérieure à 3.50 m.

Il peut également être prévu un ascenseur 3014 pour l'accès au siège 401 ou au support 4 ayant à la place de la chaise 401 le mât 4 servant au support de l'objet sous test, ainsi que représenté aux figures 1 à 10, une réservation étant prévue dans le sol pour abriter l'ascenseur 3014.

Une interface de commande, par exemple une commande électrique à bouton(s) est prévue pour ouvrir (déplacement de la première position fermée à la deuxième position écartée) et fermer (déplacement de la deuxième position écartée à la première position fermée) les parties 3001 et 3003. Un bouton à l'extérieur des parties 3001 et 3003 est par exemple prévu pour commander l'ouverture. Par exemple, durant l'ouverture de la chambre, un signal sonore et une lumière clignotante avertissent les personnes environnantes de se tenir à l'écart, ceci de façon à éviter toute blessure à toute personne se trouvant près du système. Si une personne doit être mesurée, elle doit mettre une ceinture de sécurité et les capteurs de pression sur des repose-pieds de la chaise 401 doivent être activés. L'ascenseur 3014 doit aussi s'être complètement rétracté pour pouvoir fermer de nouveau le système. L'opérateur peut alors fermer le système. La mesure peut ensuite être réalisée dans la première position fermée. Quand la mesure est terminée, la chambre peut être de nouveau ouverte, l'ascenseur remonté et la personne sous test peut sortir ou l'objet sous test être évacué.

## Revendications

1. Dispositif de test électromagnétique d'au moins un objet, le dispositif comportant un réseau de sondes (2) électromagnétiques d'émission et/ou de réception de rayonnements électromagnétiques vers ou depuis l'objet sous test, le dispositif comportant en outre une structure (3) de support du réseau de sondes (2), comportant des absorbeurs électromagnétiques anéchoïques (5), et un support (4) de l'objet sous test,
la structure (3) de support du réseau de sondes (2) étant fermée tout autour du support (4) de l'objet sous test selon les trois dimensions de l'espace par au moins une paroi conductrice (31) formant cage de Faraday, qui est munie sur son côté intérieur d'absorbeurs électromagnétiques anéchoïques (5, 51) situés dans les intervalles entre les sondes (2),
la structure (3) de support délimitant un volume clos contenant le support (4) de l'objet sous test,
le volume clos délimité par la structure (3) de support contenant en outre un système (6) de déplacement relatif du support (4) par rapport à la structure (3) de support suivant au moins un degré de liberté.
le système (6) de déplacement relatif situé à l'intérieur de la structure (3) de support est composé d'au moins un premier système (60) de déplacement angulaire relatif permettant au moins un premier déplacement angulaire (A1) déterminé de glissement de la structure (3) de support et du support (4) l'un par rapport à l'autre autour d'un axe géométrique non vertical,
**caractérisé en ce que**
la structure (3) de support repose sur un socle inférieur (61), le dispositif comportant entre le socle (61) et la structure (3) de support un deuxième autre système (63) de déplacement angulaire permettant de déplacer la structure (3) de support par rapport au socle (61) d'un deuxième angle (A2), qui est dans le même plan vertical que le premier déplacement angulaire (A1) déterminé du support (4) par rapport à la structure (3) de support, qui est de même valeur absolue que le premier déplacement angulaire (A1) déterminé et qui est opposé au premier déplacement angulaire (A1) déterminé du support (4) par rapport à la structure (3) de support, afin que le support (4) de l'objet sous test conserve une position prescrite et constante par rapport à la verticale.

2. Dispositif suivant la revendication 1, **caractérisé en ce que** la paroi conductrice (31) est courbe ou à facettes.

3. Dispositif suivant la revendication 1, **caractérisé en ce que** la structure (3) de support est de forme générale sphérique.

4. Dispositif suivant l'une quelconque des revendications précédentes, **caractérisé en ce que** la structure (3) de support comporte au moins un montant (30) auquel sont fixées les sondes (2) et la au moins une paroi conductrice (31), le dispositif comportant en outre des absorbeurs électromagnétiques anéchoïques (5) situés sur le côté intérieur des montants (30) dans les intervalles entre les sondes (2).

5. Dispositif suivant l'une quelconque des revendications précédentes, **caractérisé en ce que** la au moins une paroi conductrice (31) est fixée au côté extérieur du au moins un montant (30) par l'intermédiaire d'au moins un joint radiofréquence (32).

6. Dispositif suivant l'une quelconque des revendications précédentes, **caractérisé en ce que** la structure (3) de support du réseau de sondes (2) comporte une première partie (3001) de support d'un premier groupe de sondes (2), fixée sur un socle inférieur (3002), et une deuxième partie (3003) de support d'un deuxième groupe de sondes (2), déplaçable sur le socle inférieur (3002) entre l'une et l'autre d'une première position fermée contre la première partie (3001) pour former la cage de Faraday, et d'une deuxième position écartée par rapport à la première partie (3001) pour ménager un espace libre (3010) de passage entre la première partie (3001) et la deuxième partie (3003).

7. Dispositif suivant la revendication 6, **caractérisé en ce que** la deuxième partie (3003) est articulée autour d'un axe vertical (3004) sur le socle inférieur (3002) pour le déplacement en rotation autour de cet axe vertical (3004) entre l'une et l'autre de la première position et de la deuxième position.

8. Dispositif suivant la revendication 6 ou 7, **caractérisé en ce qu'**il comporte au moins un moteur (3019) pour déplacer la deuxième partie (3005) par rapport à la première partie (3001) entre l'une et l'autre de la première position et de la deuxième position, et apte dans la première position à maintenir la deuxième partie (3003) fermée contre la première partie (3001) pour former la cage de Faraday.

9. Dispositif suivant l'une quelconque des revendications 6 à 8, **caractérisé en ce que** la première partie (3001) et la deuxième partie (3003) comportent respectivement au moins un premier bord (3005) et au moins un deuxième bord (3006), qui sont tournés l'un vers l'autre dans la première position fermée, le premier bord (3005) et/ou le deuxième bord (3006) comportant au moins un joint élastique radiofréquence (3007) positionné pour être comprimé par l'autre des premier bord (3005) et/ou deuxième bord (3006) dans la première position fermée.

10. Dispositif suivant l'une quelconque des revendications précédentes, **caractérisé en ce que** le deuxième autre système (63) de déplacement angulaire comporte une pluralité de rouleaux (631) de soutien d'une surface extérieure courbe (310) de la paroi (31) de la structure (3) de support sur le socle (61) et au moins un moteur (64) d'entraînement d'au moins l'un des rouleaux (631) pour faire rouler dudit deuxième angle (A2) ladite surface extérieure courbe (310) de la paroi (31) de la structure (3) de support par rapport au socle (61).

11. Dispositif suivant la revendication 10, **caractérisé en ce qu'**il comporte en outre :
un organe de commande du déplacement angulaire (A1) de glissement du premier système (60) de déplacement angulaire,
au moins un capteur (66) de mesure d'un angle réel du support (4) de l'objet sous test par rapport à la verticale,
une boucle (65) d'asservissement du moteur (64) d'entraînement en fonction de l'angle mesuré par le capteur (66), pour que l'angle mesuré par le capteur (66) soit égal à une valeur constante correspondant à ladite position prescrite du support (4) par rapport à la verticale.

12. Dispositif suivant l'une quelconque des revendications précédentes, **caractérisé en ce que** les sondes (2) sont réparties de manière équiangle suivant au moins une coordonnée sphérique autour d'un même point cible (40) des sondes (2).

13. Dispositif suivant l'une quelconque des revendications précédentes, **caractérisé en ce que** le dispositif comporte en outre sur au moins une des sondes (2) un système (7) de réglage individuel de l'alignement mécanique de la sonde (2) par rapport à un même point cible (40) pour toutes les sondes (2), point cible (40) où doit être centré l'objet sous test sur le support (4).

14. Dispositif suivant la revendication précédente, **caractérisé en ce que** le système (7) de réglage individuel de l'alignement mécanique de la sonde (2) est associé à au moins une caméra optique (71) de détection positionnée au point cible (40) pour mesurer l'alignement mécanique de la sonde (2).

15. Dispositif suivant l'une quelconque des revendications 13 et 14, **caractérisé en ce que** le système (7) de réglage individuel de l'alignement mécanique de la sonde (2) comporte une motorisation (70) de ladite sonde (2) sur la structure (3) de support, pour déplacer la sonde (2) par rapport à la structure (3) de support suivant au moins un degré de liberté autre que suivant une direction (DP) de pointage de la sonde (2) vers le point cible (40).

16. Dispositif suivant la revendication 15, **caractérisé en ce que** le dispositif comporte en outre un module (74) d'analyse de l'image fournie par la caméra pour détecter dans cette image la trace (CR) de ladite sonde (2) et un module (76) d'asservissement de la motorisation (70) pour aligner la trace (CR) détectée de la sonde sur une trace (TRC) de consigne correspondant à l'alignement de la sonde (2) sur le point cible (40).

## Patentansprüche

1. Vorrichtung zum elektromagnetischen Testen von mindestens einem Objekt, wobei die Vorrichtung ein Netz von elektromagnetischen Sonden (2) zum Senden und/oder Empfangen elektromagnetischen Strahlungen hin zu oder von dem getesteten Objekt umfasst, wobei die Vorrichtung ferner eine Struktur (3) zum Tragen des Netzes von Sonden (2), die reflexionsfreie elektromagnetische Absorber (5) umfassen, und einen Träger (4) für das getestete Objekt umfasst,
wobei die Struktur (3) zum Tragen des Netzes von Sonden (2) um den gesamten Träger (4) des getesteten Objekts herum in den drei Dimensionen des Raumes durch mindestens eine einen faradayschen Käfig bildende leitfähige Wand (31) geschlossen ist, die auf ihrer Innenseite mit reflexionsfreien elektromagnetischen Absorbern (5, 51) versehen ist, die sich in den Zwischenräumen zwischen den Sonden (2) befinden,
wobei die Trägersstruktur (3) ein geschlossenes Volumen abgrenzt, das die Träger (4) des getesteten Objekts enthält,
wobei das durch die Trägersstruktur (3) abgegrenzte geschlossene Volumen ferner ein System (6) zur relativen Verlagerung des Trägers (4) in Bezug auf die Trägersstruktur (3) entlang von mindestens einem Freiheitsgrad enthält,
wobei das System (6) zur relativen Verlagerung, das sich im Inneren der Trägersstruktur (3) befindet, aus mindestens einem ersten System (60) zur relativen winkligen Verlagerung besteht, das mindestens eine erste bestimmte winklige Verschiebungsverlagerung (A1) der Trägersstruktur (3) und des Trägers (4) in Bezug zueinander um eine nicht vertikale geometrische Achse ermöglicht,
**dadurch gekennzeichnet, dass**
die Trägersstruktur (3) auf einem unteren Sockel (61) ruht, wobei die Vorrichtung zwischen dem Sockel (61) und der Trägersstruktur (3) ein zweites, anderes System (63) zur winkligen Verlagerung umfasst, das das Verlagern der Trägersstruktur (3) in Bezug auf den Sockel (61) um einen zweiten Winkel (A2) ermöglicht, der sich in der gleichen vertikalen Ebene wie die erste bestimmte winklige Verlagerung (A1) des Trägers (4) in Bezug zu der Trägersstruktur (3) befindet, die den gleichen Absolutwert wie die erste bestimmte winklige Verlagerung (A1) aufweist und die der ersten bestimmten winkligen Verlagerung (A1) des Trägers (4) in Bezug zu der Trägersstruktur (3) entgegengesetzt ist, damit die Träger (4) des getesteten Objekts eine vorgeschriebene und konstante Position in Bezug auf die Vertikale bewahrt.

2. Vorrichtung nach Anspruch 1, **dadurch gekennzeichnet, dass** die leitfähige Wand (31) gekrümmt oder mit Facetten ist.

3. Vorrichtung nach Anspruch 1, **dadurch gekennzeichnet, dass** die Trägersstruktur (3) eine allgemein kugelförmige Form aufweist.

4. Vorrichtung nach einem der vorhergehenden Ansprüche, **dadurch gekennzeichnet, dass** die Trägersstruktur (3) mindestens eine Stütze (30) umfasst, an der die Sonden (2) und die mindestens eine leitfähige Wand (31) befestigt sind, wobei die Vorrichtung ferner reflexionsfreie elektromagnetische Absorber (5) umfasst, die sich auf der Innenseite der Stützen (30) in den Zwischenräumen zwischen den Sonden (2) befinden.

5. Vorrichtung nach einem der vorhergehenden Ansprüche, **dadurch gekennzeichnet, dass** die mindestens eine leitfähige Wand (31) an der Außenseite der mindestens einen Stütze (30) über mindestens eine Hochfrequenzdichtung (32) befestigt ist.

6. Vorrichtung nach einem der vorhergehenden Ansprüche, **dadurch gekennzeichnet, dass** die Struktur (3) zum Tragen des Netzes von Sonden (2) einen ersten Teil (3001) zum Tragen einer ersten Gruppe von Sonden (2), der an einem unteren Sockel (3002) befestigt ist, und einen zweite Teil (3003) zum Tragen einer zweiten Gruppe von Sonden (2) umfasst, der an dem unteren Sockel (3002) zwischen einer von einer ersten, gegen den ersten Teil (3001) geschlossenen Position zum Bilden des faradayschen Käfigs, und einer zweiten Position, die in Bezug zu dem ersten Teil (3001) beabstandet ist, um einen freien Durchgangsraum (3010) zwischen dem ersten Teil (3001) und dem zweiten Teil (3003) einzurichten, und der anderen verlagerbar ist.

7. Vorrichtung nach Anspruch 6, **dadurch gekennzeichnet, dass** der zweite Teil (3003) um eine vertikale Achse (3004) auf dem unteren Sockel (3002) zur drehbaren Verlagerung um diese vertikale Achse (3004) zwischen einer von der ersten Position und der zweiten Position und der anderen gelenkig gelagert ist.

8. Vorrichtung nach Anspruch 6 oder 7, **dadurch gekennzeichnet, dass** sie mindestens einen Motor (3019) zum Verlagern des zweiten Teils (3005) in Bezug zu dem ersten Teil (3001) zwischen einer von der ersten Position und der zweiten Position und der anderen umfasst, und dass der Motor in der ersten Position geeignet ist, den zweiten Teil (3003) geschlossen gegen den ersten Teil (3001) zu halten, um den faradayschen Käfig zu bilden.

9. Vorrichtung nach einem der Ansprüche 6 bis 8, **dadurch gekennzeichnet, dass** der erste Teil (3001) und der zweite Teil (3003) jeweils mindestens einen ersten Rand (3005) und mindestens einen zweiten Rand (3006) umfassen, die einander in der ersten, geschlossenen Position zugewandt sind, wobei der erste Rand (3005) und/oder der zweite Rand (3006) mindestens eine elastische Hochfrequenzdichtung (3007) umfassen, die positioniert ist, um von dem anderen von dem ersten Rand (3005) und/oder dem zweiten Rand (3006) in der ersten, geschlossenen Position zusammengedrückt zu werden.

10. Vorrichtung nach einem der vorhergehenden Ansprüche, **dadurch gekennzeichnet, dass** das zweite, andere System (63) zur winkligen Verlagerung mehrere Rollen (631) zum Stützen einer gekrümmten Außenfläche (310) der Wand (31) der Trägersstruktur (3) auf dem Sockel (61) und mindestens einen Motor (64) für den Antrieb von mindestens einer von den Rollen (631) umfasst, um die gekrümmte Außenfläche (310) der Wand (31) der Trägersstruktur (3) um den zweiten Winkel (A2) in Bezug zu dem Sockel (61) zum Rollen zu bringen.

11. Vorrichtung nach Anspruch 10, **dadurch gekennzeichnet, dass** sie ferner umfasst:
ein Organ zur Betätigung der winkligen Verschiebungsbewegung (A1) des ersten Systems (60) zur winkligen Verlagerung,
mindestens einen Sensor (66) zum Messen eines effektiven Winkels des Trägers (4) des getesteten Objekts in Bezug auf die Vertikale,
einen Regelkreis (65) zur Regelung des Antriebsmotors (64) in Abhängigkeit von dem durch den Sensor (66) gemessenen Winkel, damit der durch den Sensor (66) gemessene Winkel gleich einem konstanten Wert ist, der der vorgeschriebenen Position des Trägers (4) in Bezug auf die Vertikale entspricht.

12. Vorrichtung nach einem der vorhergehenden Ansprüche, **dadurch gekennzeichnet, dass** die Sonden (2) auf eine gleichwinklige Weise entlang mindestens einer Kugelkoordinate um einen gleichen Zielpunkt (40) der Sonden (2) verteilt sind.

13. Vorrichtung nach einem der vorhergehenden Ansprüche, **dadurch gekennzeichnet, dass** die Vorrichtung ferner auf mindestens einer von den Sonden (2) ein System (7) zur individuellen Regelung der mechanischen Ausrichtung der Sonde (2) in Bezug auf einen gleichen Zielpunkt (40) für alle Sonden (2) umfasst, wobei das getestete Objekt auf der Träger (4) auf diesen Zielpunkt (40) zentriert sein muss.

14. Vorrichtung nach dem vorhergehenden Anspruch, **dadurch gekennzeichnet, dass** das System (7) zur individuellen Regelung der mechanischen Ausrichtung der Sonde (2) mit mindestens einer optischen Detektionskamera (71) verbunden ist, die an dem Zielpunkt (40) positioniert ist, um die mechanische Ausrichtung der Sonde (2) zu messen.

15. Vorrichtung nach einem der Ansprüche 13 und 14, **dadurch gekennzeichnet, dass** das System (7) zur individuellen Regelung der mechanischen Ausrichtung der Sonde (2) eine Motorisierung (70) der Sonde (2) auf der Trägerstruktur (3) umfasst, um die Sonde (2) in Bezug auf die Trägerstruktur (3) entlang von mindestens einem Freiheitsgrad zu verlagern, der sich von entlang einer Zielrichtung (DP) der Sonde (2) hin zum Zielpunkt (40) unterscheidet.

16. Vorrichtung nach Anspruch 15, **dadurch gekennzeichnet, dass** die Vorrichtung ferner ein Modul (74) zur Analyse des durch die Kamera gelieferten Bildes, um in diesem Bild die Spur (CR) der Sonde (2) zu detektieren, und ein Modul (76) zur Regelung der Motorisierung (70) umfasst, um die detektierte Spur (CR) der Sonde auf eine Einstellspur (TRC) auszurichten, die der Ausrichtung der Sonde (2) auf den Zielpunkt (40) entspricht.

## Claims

1. A device for the electromagnetic testing of at least one object, the device comprising a network of electromagnetic probes (2) for transmission and/or for reception of electromagnetic radiations towards or from the object being tested, the device also comprising a support structure (3) for supporting the network of probes (2), comprising anechoic electromagnetic absorbers (5), and a support (4) for supporting the object being tested,
wherein the support structure (3) for supporting the network of probes (2) is closed in the three dimensions of space all around the support (4) for the object being tested by at least one conductive wall (31) forming a Faraday cage which is fitted on its inner side by anechoic electromagnetic absorbers (5, 51) located in the intervals between the probes (2),
wherein the support structure (3) delimits a closed volume containing the support (4) for the object being tested,
wherein the closed volume delimited by the support structure (3) also contains a relative displacement system (6) for relative displacement of the support (4) relative to the support structure (3) according to at least one degree of liberty,
wherein the relative displacement system (6) located inside the support structure (3) is constituted by at least one first relative angular displacement system (60) enabling at least one first determined sliding angular displacement (A1) of the support structure (3) and of the support (4) relative to each other about a non-vertical geometric axis,
**characterised in that**
the support structure (3) rests on a lower base (61), wherein the device comprises between the base (61) and the support structure (3) a second other angular displacement system (63) enabling to displace the support structure (3) relative to the base (61) by a second angle (A2), which is in the same vertical plane as the first determined sliding angular displacement (A1) of the support (4) relative to the support structure (3), which is of the same absolute value as the first determined sliding angular displacement (A1) and which is opposite the first determined sliding angular displacement (A1) of the first relative angular displacement system (60) of the support (4) relative to the support structure (3), so that the support (4) for the object being tested retains a prescribed and constant position relative to the vertical.

2. The device according to Claim 1, **characterised in that** the conductive wall (31) is curved or is facetted.

3. The device according to Claim 1, **characterised in that** the support structure (3) has a general spherical shape.

4. The device according to any one of the preceding claims, **characterised in that** the support structure (3) comprises at least one upright (30) to which are fixed the probes (2) and the at least one conductive wall (31), wherein the device also comprises anechoic electromagnetic absorbers (5) situated on the inner side of the uprights (30) in the intervals between the probes (2).

5. The device according to any one of the preceding claims, **characterised in that** the at least one conductive wall (31) is fixed to the outer side of the at least one upright (30) by means of at least one radiofrequency joint (32).

6. The device according to any one of the preceding claims, **characterised in that** the support structure (3) of the network of probes (2) comprises a first part (3001) for supporting a first group of probes (2), fixed on a lower base (3002), and a second part (3003) for supporting a second group of probes (2), movable on the lower base (3002) between one and the other of a first position closed against the first part (3001) to form the Faraday cage, and a second position removed relative to the first part (3001) to make a free passage space (3010) between the first part (3001) and the second part (3003).

7. The device according to Claim 6, **characterised in that** the second part (3003) is articulated about a vertical axis (3004) on the lower base (3002) for displacement in rotation about this vertical axis (3004) between one and the other of the first position and of the second position.

8. The device according to Claim 6 or 7, **characterised in that** it comprises at least one motor (3019) to move the second part (3005) relative to the first part (3001) between one and the other of the first position and of the second position, and in the first position capable of keeping the second part (3003) closed against the first part (3001) to form the Faraday cage.

9. The device according to any one of Claims 6 to 8, **characterised in that** the first part (3001) and the second part (3003) comprise respectively at least one first edge (3005) and at least one second edge (3006), which are turned towards each other in the first closed position, the first edge (3005) and/or the second edge (3006) comprising at least one radiofrequency elastic joint (3007) positioned to be compressed by the other of the first edge (3005) and/or second edge (3006) in the first closed position.

10. The device according to any one of the preceding claims, **characterised in that** the second other angular displacement system (63) comprises a plurality of support rollers (631) for supporting an outer curved surface (310) of the wall (31) of the support structure (3) on the base (61) and at least one drive motor (64) for driving at least one of the rollers (631) to make said outer curved surface (310) of the wall (31) of the support structure (3) roll relative to the base (61) by said second angle (A2).

11. The device according to Claim 10, **characterised in that** it also comprises:
a control element for controlling the sliding angular displacement (A1) of the first angular displacement system (60),
at least one sensor (66) for measuring a real angle of the support (4) for the object being tested relative to the vertical,
a feedback loop (65) for controlling the drive motor (64) as a function of the angle measured by the sensor (66), so that the angle measured by the sensor (66) is equal to a constant value corresponding to said prescribed position of the support (4) relative to the vertical.

12. The device according to any one of the preceding claims, **characterised in that** the probes (2) are distributed equiangularly according to at least one spherical coordinate about a same target point (40) of the probes (2).

13. The device according to any one of the preceding claims, **characterised in that** the device comprises also on at least one of the probes (2) an individual regulating system (7) for regulating the mechanical alignment of the probe (2) relative to a same target point (40) for all the probes (2), a target point (40) where the object being tested must be centred on the support (4).

14. The device according to the preceding claim, **characterised in that** the individual regulating system (7) for regulating the mechanical alignment of the probe (2) is associated to at least one optical detection camera (71) positioned at the target point (40) to measure the mechanical alignment of the probe (2).

15. The device according to any one of Claims 13 and 14, **characterised in that** the individual regulating system (7) for regulating the mechanical alignment of the probe (2) comprises motorisation (70) of said probe (2) on the support structure (3) to move the probe (2) relative to the support structure (3) according to at least one degree of liberty other than in an aiming direction (DP) of the probe (2) towards the target point (40).

16. The device according to Claim 15, **characterised in that** the device comprises also an analysis module (74) for analysing the image supplied by the camera to detect in this image the trace (CR) of said probe (2) and a feedback module (76) for controlling the motorisation (70) to align the detected trace (CR) of the probe on a setpoint trace (TRC) corresponding to the alignment of the probe (2) on the target point (40).
